(19) Europäisches Patentamt
European Patent Office
Office européen des brevets

(11) Veröffentlichungsnummer: **0 237 875 B1**

# (12) EUROPÄISCHE PATENTSCHRIFT

(45) Veröffentlichungstag der Patentschrift: **13.03.91**

(51) Int. Cl.$^5$: **C08G 8/12**, C08G 8/00

(21) Anmeldenummer: **87103124.1**

(22) Anmeldetag: **05.03.87**

## (54) Verfahren zum Abtrennen von höhermolekularen Bestandteilen aus Phenolpolymeren.

(30) Priorität: **14.03.86 DE 3608492**

(43) Veröffentlichungstag der Anmeldung:
**23.09.87 Patentblatt 87/39**

(45) Bekanntmachung des Hinweises auf die Patenterteilung:
**13.03.91 Patentblatt 91/11**

(84) Benannte Vertragsstaaten:
**AT BE CH DE FR GB IT LI NL SE**

(56) Entgegenhaltungen:
**EP-A- 0 144 880**
**DE-A- 3 222 485**

**CHEMICAL ABSTRACTS, Band 98, Nr. 26, 27. Juni 1983, Seite 616, Spalte 1, Zusammenfassungsnr. 225293w, Columbus, Ohio, US; & JP - A - 57 86830**

**CHEMICAL ABSTRACTS, Band 68, Nr. 16, 15. April 1968, Seite 7626, Spalte 1, Zusammenfassungsnr. 78918d, Columbus, Ohio, US; S. ISHIDA "Fractionation of phenol-formaldehyde condensation products", & KOGYO KAGAKU ZASSHI, 1967, 70(2), 203-205**

(73) Patentinhaber: **HOECHST AKTIENGESELLSCHAFT**
**Postfach 80 03 20**
**W-6230 Frankfurt am Main 80(DE)**

(72) Erfinder: **Schneller, Arnold, Dr.**
**Asternweg 41**
**W-6500 Mainz-Finthen(DE)**
Erfinder: **Lambert, Gabriele**
**Dreiweidenstrasse 1**
**W-6200 Wiesbaden(DE)**

**EP 0 237 875 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Abtrennen von höhermolekularen Bestandteilen aus Phenolpolymeren, insbesondere die Abtrennung von höhermolekularen Verbindungen aus gegebenenfalls substituierten Phenol-Formaldehyd-Kondensaten.

Phenolpolymere besitzen eine große Bedeutung als Rohstoffe für die Herstellung von Formteilen und Preßmassen, als Schutzlacke für Metalle oder als Isoliermaterialien im Verbund mit Epoxyharzen. Daneben haben sich in jüngerer Zeit neue Einsatzgebiete eröffnet, etwa als feuerfeste Fasern, als Trägermaterial für Ionenaustauscher oder als Bindemittel in Kopiermaterialien wie Photoresists. Mit diesen neuen Möglichkeiten der Anwendung steigen jedoch auch die Anforderungen an die Polymeren. Im Handel erhältliche Phenolpolymere enthalten mehr oder weniger große Mengen an niedermolekularen Bestandteilen, was sich für viele Anwendungen nachteilig auswirkt. So führt die Verarbeitung der Phenolpolymeren bei höheren Temperaturen aufgrund des hohen Dampfdruckes der niedermolekularen Bestandteile zu einer beträchtlichen Umweltbelastung, so daß aufwendige Absaugvorrichtungen notwendig werden. Der relativ hohe Gehalt an niedermolekularen Verbindungen ist auch verantwortlich für die niedrige Erweichungstemperatur der Phenolpolymeren. Dieser gravierende Nachteil macht sich vor allem bei Anwendungen der Phenolpolymeren in höheren Temperaturbereichen bemerkbar, etwa beim Einsatz als Bindemittel in Photoresists. Bei Temperaturen oberhalb von 140 °C verlaufen die photochemisch erzeugten Strukturen in unerwünschter Weise und führen zu einer ungenügenden, geringen Auflösung.

Es ist bekannt (EP-A 0 144 880) zur Abtrennung von unerwünschten niedermolekularen Bestandteilen die fraktionierte Fällung von Novolaken durchzuführen. Dazu werden die Novolake in einem geeigneten Lösungsmittel gelöst und durch Zugabe eines Fällungsmittels wieder ausgefällt. Diese Methode erfordert eine genaue Auswahl der entsprechenden Lösungs- oder Fällungsmittel und eine exakte Einhaltung der Temperatur, um reproduzierbare Ergebnisse zu erhalten.

In der DE-A 3 222 485 (entsprechend US-A 4,348,471) werden säurefreie Harze beschrieben, wobei Novolake mit Basen, wie zum Beispiel tertiären Aminen behandelt werden, um durch Neutralisation die für die Herstellung der Novolake zugesetzte Säure zu entfernen. Eine Fraktionierung der Novolake wird nicht beschrieben.

Es war Aufgabe der Erfindung, ein Verfahren zum Abtrennen von höhermolekularen Bestandteilen aus Phenolpolymeren zu schaffen, um hierdurch ein Material mit hoher Wärmebeständigkeit, hohem Molekulargewicht und mit enger Molekulargewichtsverteilung zur Verfügung zu stellen.

Die Lösung dieser Aufgabe ist bei dem eingangs beschriebenen Verfahren dadurch gekennzeichnet, da man das Phenolpolymer in einem organischen Lösungsmedium löst, die Lösung bei Raumtemperatur mit Ammoniak oder einem Amin im stöchiometrischen Unterschuß versetzt, das Ausgefallene abtrennt, gegebenenfalls trocknet und dann mit wäßriger Säure behandelt und den resultierenden Niederschlag abfiltriert, wäscht und trocknet. Als organisches Lösungsmedium dient dabei ein organisches Lösungsmittel oder ein organisches Lösungsmittelgemisch. Die Lösung wird vorzugsweise mit etwa 1 bis 40 Molprozent an Ammoniak oder Amin versetzt. Vorzugsweise nimmt man das Ausgefallene in einem organischen Lösungsmedium auf und behandelt dann mit wäßriger Säure.

Die Erfindung wird anhand der durch Gelpermeationschromatographie erhaltenen, beigefügten Diagramme (GPC-Diagramme) näher erläutert. Figur 1 zeigt ein GPC-Diagramm eines unbehandelten Phenolpolymeren, aufgenommen mit einem handelsüblichen Gelpermeationschromatographen, wobei der Berechnungsindex (n) als der der Häufigkeit der Einzelmoleküle analogen Größe gegen das Molekulargewicht (MG) aufgetragen ist. Im Vergleich dazu zeigt Figur 2 das GPC-Diagramm des gleichen Phenolpolymeren, jedoch nach der erfindungsgemäßen Behandlung. Man erkennt deutlich, daß die Peaks im niedermolekularen Bereich verschwunden sind. Das Maximum der Kurve in Figur 2 ist zu höheren Molekulargewichten verschoben. Gleichzeitig ist die Molekulargewichtsverteilung wesentlich enger.

Unter Phenolpolymer sollen Polymere mit phenolischen Hydroxy-Gruppen verstanden werden. Insbesondere wird ein Kondensationsprodukt aus gegebenenfalls substituiertem Phenol und Formaldehyd verwendet, ausgedrückt durch die allgemeine Formel I

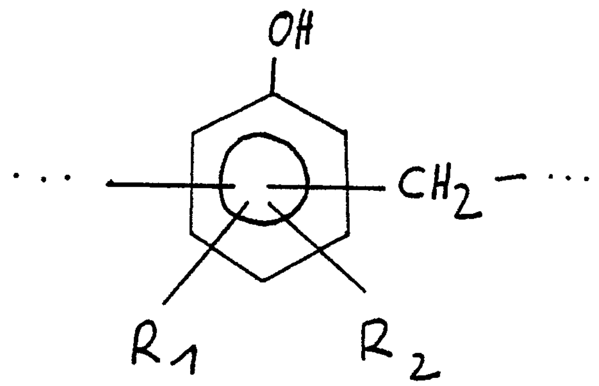

(I)

worin

$R_1$ und $R_2$ gleich oder verschieden sind und Wasserstoff und/oder verzweigte bzw. unverzweigte Alkylreste mit ein bis neun Kohlenstoffatomen

bedeuten.

Vorzugsweise stellen

$R_1$ ein Wasserstoffatom und

$R_2$ eine verzweigte oder unverzweigte Alkylkette mit einem bis vier Kohlenstoffatomen dar, insbesondere einen Methyl- oder tert. Butylrest.

Beispiele für bevorzugt verwendete Phenolpolymere sind demgemäß Novolake aus Phenol, Kresol oder tert. Butylphenol und Formaldehyd. Einen Überblick über diese Verbindungen geben A. Knop und W. Scheib in "Chemistry and Application of Phenolic Resins", Springer-Verlag 1979.

Die erfindungsgemäß einsetzbaren Phenolpolymere können sowohl aus gleichen als auch aus strukturell unterschiedlichen, wiederkehrenden Einheiten aufgebaut sein.

Das erfindungsgemäße Verfahren läßt sich allgemein für die Abtrennung von höhermolekularen Bestandteilen aus Polymeren mit phenolischen Hydroxygruppen anwenden.

Das Molekulargewicht der für das erfindungsgemäße Verfahren einsetzbaren Phenolpolymeren als Ausgangsstoffe unterliegt nach oben keinerlei Beschränkungen. Die untere Grenze richtet sich nach der Struktur und dem Gehalt an niedermolekularen Verbindungen. Bevorzugt werden Polymere mit einem Molekulargewicht größer 500 eingesetzt.

Der Gehalt der durch das erfindungsgemäße Verfahren abtrennbaren höhermolekularen Bestandteile liegt im allgemeinen zwischen 99,5 - 50 Gewichtsprozent, bevorzugt zwischen 99 - 60 Gewichtsprozent, bezogen auf das Ausgangs-Phenolpolymer.

Als organisches Lösungsmedium der Phenolpolymeren für das erfindungsgemäße Verfahren kommen organische Lösungsmittel wie Aceton, Methylethylketon, Methylisobutylketon, die Methyl-, Ethyl-, Propyl- und Butylester der Essigsäure, Methoxypropylacetat, Methylglykol und Alkohole wie z.B. Ethanol, Isopropanol, Butanol, oder Mischungen aus den genannten Verbindungen in Betracht. Die Auswahl der geeigneten Lösungsmittel richtet sich nach der Struktur und der Polarität der eingesetzten Phenolpolymeren. Das Lösungsmedium kann zu diesem Zweck auch unpolare organische Lösungsmittel, wie Kohlenwasserstoffe, etwa n-Hexan enthalten.

Im erfindungsgemäßen Verfahren wird eine organische Lösung des Phenolpolymeren mit Ammoniak oder einem Amin in stöchiometrischen Unterschuß behandelt. Es wird angenommen, ohne damit andere Deutungsweisen auszuschließen, daß dabei eine Wechselwirkung zwischen den sauren phenolischen Gruppen und dem basischen Stickstoff stattfindet. In Abhängigkeit von der Molekulargröße führt diese Wechselwirkung zu einer Ausfällung der höhermolekularen Bestandteile, während die niedermolekularen Bestandteile in Lösung bleiben und somit voneinander getrennt werden.

Der Zusatz erfolgt vorzugsweise tropfenweise und wird solange durchgeführt, wie durch diesen Zusatz Ausfällung hervorgerufen wird.

Die im erfindungsgemäßen Verfahren außer Ammoniak einsetzbaren Amine sind Verbindungen, die eine Säurekonstante $pK_a$ von größer etwa 6 in wäßriger Lösung bei 25 °C besitzen. Vorzugsweise werden Verbindungen verwendet mit $pK_a$ größer etwa 9 (nach Handbook of Chemistry and Physics, S. D 147 - D 149, 58. Aufl. 1977).

Hierzu gehören beispielsweise Mono-, Di- oder Trialkylamine, wie Ethylamin, Propylamin, Butylamin, Dimethylamin, Diethylamin, Dipropylamin, Dibutylamin, Trimethylamin, Triethylamin, Tributylamin, Ethylendiamin, Cyclohexylamin oder Piperidin.

Besonders bevorzugt werden Triethylamin, Cyclohexylamin, Piperidin oder Ethylendiamin verwendet. Es können auch Mischungen der Amine eingesetzt werden.

Die Konzentration der vorgelegten organischen Lösung des Phenolpolymeren beträgt im allgemeinen etwa 1 bis 50 Gewichtsprozent, vorzugsweise 5 bis 40 Gewichtsprozent, bezogen auf das Gewicht der Lösung.

Die Menge des Ammoniaks bzw. des Amins, die für das erfindungsgemäße Verfahren verwendet wird, beträgt vorzugsweise etwa 1 bis 40 Molprozent bezogen auf das Ausgangs-Phenolpolymer.

Bei dem erfindungsgemäßen Verfahren wird das Phenolpolymere gewöhnlich nach der Auflösung in dem organischen Lösungsmittel direkt mit Ammoniak oder dem Amin, das gegebenenfalls gelöst in dem für das Phenolpolymere verwendeten Lösungsmittel vorliegt, bei Zimmertemperatur behandelt. Das Ausgefallene wird durch Zentrifugieren oder Filtrieren abgetrennt und nach eventueller Zwischentrocknung mit wäßriger Säure versetzt. Anschließend wird der so von niedermolekularen Bestandteilen befreite Niederschlag nach den üblichen Methoden getrocknet.

Die Behandlung der organischen Lösung des Phenolpolymeren mit Ammoniak oder dem Amin wird bei Raumtemperatur während 0,5 bis 5 Stunden durchgeführt, gewöhnlich genügt bereits eine Stunde, um eine saubere Abtrennung zu erreichen.

Die Behandlung des Ausgefallenen mit wäßriger Säure kann derart erfolgen, daß man die getrocknete Substanz direkt behandelt. Eine Aufnahme des Ausgefallenen in einem organischen Lösungsmedium und die anschließende Behandlung mit wäßriger Säure wird bevorzugt.

Als einsetzbare Säuren kommen anorganische oder organische Säuren wie Salzsäure, Salpetersäure, Schwefelsäure, Essigsäure etc. in wäßriger Form in Frage. Die verwendete Menge der sauren Verbindung richtet sich nach der Menge des zuvor zugesetzten Ammoniaks oder Amins. Im allgemeinen arbeitet man mit einem geringen Überschuß an Säure, bezogen auf die Menge des eingesetzten Ammoniaks oder Amins. Es lassen sich mit Erfolg auch saure Ionenaustauscher zur Freisetzung des Phenols verwenden.

Nach dem erfindungsgemäßen Verfahren lassen sich höhermolekulare Phenolpolymere in einfachen Verfahrensschritten von niedermolekularen Bestandteilen abtrennen. Die auf diese Weise hergestellten Polymeren sind farb- und geruchslose Pulver mit im Vergleich zu den Ausgangsprodukten höheren Molekulargewichten und engeren Molekulargewichtsverteilungen. Die damit verbundene grundsätzliche Verbesserung der thermischen und mechanischen Eigenschaften von solchen Polymeren, wie z.B. Glastemperatur, Filmbildung, Reißfestigkeit u.ä ist offensichtlich. Zusätzlich ist die Freisetzung von Monomeren oder anderen niedermolekularen Bestandteilen beim Erhitzen von diesen nach dem erfindungsgemäßen Verfahren behandelten Polymeren vollständig unterbunden. Damit treten keine Probleme durch Verunreinigungen oder wegen gesundheitlicher Belästigung auf.

Die Erfindung ist auch auf eine durch das erfindungsgemäße Verfahren hergestellte Fraktion der höhermolekularen Bestandteile aus Phenolpolymeren, die ein erhöhtes osmometrisches Molekulargewicht und eine erhöhte Glastemperatur gegenüber dem Ausgangs-Phenolpolymer besitzt, gerichtet. Dabei sind solche Fraktionen besonders bevorzugt, deren osmometrisches Molekulargewicht um einen Faktor von etwa 3 und deren Glastemperatur um einen Faktor von etwa 1,5 erhöht ist.

Mit den erfindungsgemäßen Phenolpolymeren lassen sich nach bekannten Verfahren Preßmassen herstellen. Als Füllstoffe kommen anorganische Mineralstoffe, z.B. Kalkstein oder Glasfasern, oder auch organische Materialien, z.B. Holzmehl in Betracht. Die so hergestellten Preßmassen können aufgrund der geringen Eigenfärbung der eingesetezten Phenolpolymeren mit einem wesentlich breiteren Sortiment an Farben eingefärbt werden als bisher bekannte Materialien.

Die höhere Glastemperatur der eingesetzten Phenolpolymeren äußert sich in einer höheren Wärmefestigkeit der damit hergestellten Werkstoffe.

Die Erfindung wird anhand der Beispiele erläutert, ohne sie hierauf zu beschränken.

Beispiel 1

75 g eines Novolakharzes, hergestellt durch saure Kondensation eines Gemisches aus m-, p- oder o-Kresol mit Formaldehyd werden in 300 ml Ethylacetat gelöst. Zu der Lösung werden anschließend 150 ml n-Hexan zugegeben. Nach Filtration von unlöslichen Bestandteilen werden unter Rühren 11 ml Triethylamin während 15 Minuten zugetropft. Der entstehende farblose Niederschlag wird abgesaugt, mit 200 ml des Lösungsmittelgemisches nachgewaschen und anschließend im Vakuum bei Raumtemperatur 10 Stunden lang getrocknet.

23 g des so behandelten Novolaks werden in 250 ml Aceton gelöst und unter Rühren in 2,5 l etwa 5 prozentige wäßrige HCl getropft. Das ausgefallene Polymer wird abgesaugt, mit destilliertem Wasser neutral

gewaschen und im Vakuum 24 Stunden bei Raumtemperatur getrocknet.

Analysenwerte des unbehandelten und nach dem erfindungsgemäßen Verfahren behandelten Novolaks:

| | unbehandelt | behandelt mi Amin/Säure |
|---|---|---|
| osmometrisches Mol.gew. | 1180 | 3690 |
| Glastemperatur °C | 88 | 126 |
| $M_n$ (aus GPC) | 1400 | 3300 |
| $M_w$ (aus GPC) | 13300 | 18050 |
| Uneinheitlichkeit (aus GPC) | 9,5 | 5,5 |

Unter $M_n$ ist das Zahlenmittel des Molekulargewichts, unter $M_w$ das Gewichtsmittel zu verstehen. Die Uneinheitlichkeit ist definitionsgemäß der Quotient aus $M_w$ und $M_n$ ($M_w/M_n$).

Beispiel 2

150 g eines kommerziell erhältlichen Novolaks (Alnovol® PN 430) werden in 700 ml Isopropanol gelöst. Unter Rühren wird dazu gasförmiger Ammoniak bei Raumtemperatur solange eingeleitet, bis keine Ausfällung mehr stattfindet. Nach beendeter Einleitung läßt man 10 Minuten nachrühren, filtriert das Ausgefallene ab und wäscht mit 150 ml Isopropanol nach.

100 g des so behandelten Novolaks werden in 200 ml Aceton gelöst und unter Rühren aus 5 l 1n $H_2SO_4$ ausgefällt. Nach Waschen mit destilliertem Wasser wird der Novolak für 24 Stunden bei 30 °C im Vakuum getrocknet.

Analysenwerte des unbehandelten und des nach dem erfindungsgemäßen Verfahren behandelten Novolaks:

| | unbehandelt | behandelt mit Amin/Säure |
|---|---|---|
| osmometrisches Mol.gew. | 800 | 2400 |
| Glastemperatur °C | 89 | 121 |
| $M_n$ (aus GPC) | 1400 | 4000 |
| $M_w$ (aus GPC) | 6900 | 20800 |
| Uneinheitlichkeit | 4,9 | 5,2 |

Beispiel 3

50 g eines kommerziell erhältlichen Novolaks (Alnovol ® PN320) werden in 300 ml Ethylacetat und 200 ml n-Hexan gelöst. Unter Rühren werden dann dazu 6 ml Triethylamin bei Raumtemperatur zugetropft. Nach beendeter Zugabe läßt man 10 Minuten nachrühren, filtriert ab und wäscht mit 150 ml des Lösungsmittelgemisches nach.

30 g des so behandelten Novolaks werden in 100 ml Aceton gelöst und unter Rühren aus 3 l 1n HCl ausgefällt. Nach Waschen mit destilliertem Wasser wird der Novolak-Niederschlag für 24 Stunden bei 30 °C im Vakuum getrocknet.

Analysenwerte des unbehandelten und des nach dem erfindungsgemäßen Verfahren behandelten Novolaks:

| | unbehandelt | behandelt mit Amin/Säure |
|---|---|---|
| osmometrisches Mol.gew. | 655 | 2360 |
| Glastemperatur °C | 71 | 90 |
| $M_n$ (aus GPC) | 1060 | 2800 |
| $M_w$ (aus GPC) | 3640 | 7275 |
| Uneinheitlichkeit | 3,4 | 2,6 |

Beispiel 4

125 g eines Novolakharzes, hergestellt durch saure Kondensation eines Gemisches aus m- und p-Kresol mit Formaldehyd werden in 400 ml eines Gemisches aus Ethylacetat und Hexan (2 :1 Volumenteile) gelöst. Unter intensivem Rühren werden 22 ml Piperidin zugetropft. Das Ausgefallene wird abgesaugt und mit Lösungsmittelgemisch nachgewaschen.

Zur Überprüfung der Fällung auf Vollständigkeit werden dem Filtrat nochmals 12 ml Piperidin zugegeben. Dabei tritt keine Fällung auf. 40 g des oben isolierten Niederschlags werden in 100 ml Aceton gelöst und unter Rühren in 3 l 1n $H_2SO_4$ getropft. Der Niederschlag wird abgesaugt, gewaschen und im Vakuum getrocknet. (Ausbeute: 28 g)

Analysenwerte des unbehandelten und nach dem erfindungsgemäßen Verfahren behandelten Novolaks:

| | unbehandelt | behandelt mit Amin/Säure |
|---|---|---|
| osmometrisches Mol.gew. | 1070 | 3350 |
| Glastemperatur °C | 87 | 128 |
| $M_n$ (aus GPC) | 1350 | 3800 |
| $M_w$ (aus GPC) | 11600 | 16200 |
| Uneinheitlichkeit | 8.6 | 4,3 |

Anwendungsbeispiel 1:

Herstellung einer Preßmasse aus hochmolekularem Novolak und Hexamethylentetramin:

35 Gt (Gewichtsteile) eines nach dem erfindungsgemäßen Verfahren aus einem kommerziell erhältlichen Phenolharz (Alnovol ® PN 430) hergestellten hochmolekularen Novolaks nach Beispiel 2 werden mit 5 Gt Hexamethylentetramin, 50 Gt Holzmehl, 15 Gt Kalkstein, 1 Gt Zinkstearat und 1 Gt Magnesiumoxid gut gemischt und durch Kalandrieren bei 100 °C weiter innig vereinigt. Anschließend wird die durch das Kalandrieren ankondensierte Masse fein vermahlen und bei 160 °C und einem Druck von 100 kg/cm² verpreßt. Die Erhitzungszeit beträgt etwa 1 min. je 1 mm Schichtdicke.

Die anwendungstechnische Prüfung der so hergestellten Körper ergibt folgende Werte:

| | |
|---|---|
| Biegefestigkeit (nach DIN 53 452) | 80 $N/mm^2$ |
| Formbeständigkeit nach Martens (DIN 53 458) | 140 °C |

Die angegebenen Werte zeigen den Vorteil der neuen Novolake: Aufgrund der höheren Glastemperatur liegt die Formbeständigkeit in der Wärme deutlich über den sonst mit diesen Formulierungen erreichbaren Werten , die bei 70 $N/mm^2$ und 125 °c liegen.

Anwendungsbeispiel 2:

Herstellung eines Photoresists aus hochmolekularem Novolak mit verbessertem Wärmestand:

7 Gt eines nach dem erfindungsgemäßen Verfahren aus einem Kresol-Formaldehyd-Kondensat hergestellten hochmolekularen Novolaks,
3 Gt des Veresterungsproduktes aus 1 mol 2,3,4-Trihydroxybenzophenon und 3 mol Naphthochinon-(1,2)-diazid-(2)-5-sulfonsäurechlorid, werden in
45 Gt Methylethylketon und
45 Gt Ethanol gelöst.

Die Lösung wird anschließend durch ein Filter von 0,2 µm Porendurchmesser filtriert und auf einen oberflächlich oxydierten Siliciumwafer aufgeschleudert und getrocknet. Es resultiert eine Schichtdicke von ca. 1,7 µm.

Der Wafer wird im Kontakt mit einer Testbildmaske 15 Sekunden mit einer Intensität von 4,5 $mJ/cm^2$ bei 365 nm belichtet und in einer Lösung aus 5,3 Gt Natriummetasilikat, 3,4 Gt Trinatriumphosphat und 91,3 Gt Wasser entwickelt.

Das erhaltene Bildmuster zeigt eine Auflösung von ca. 1.0 µm.

Anschließend wird die strukturierte Resistschicht für 30 Minuten bei 150 °C getempert. Die Untersuchung der Strukturen im Mikroskop zeigt keine Abrundungen an den Kanten oder ein Verlaufen der Linien.

Im Vergleich dazu zeigen Schichten mit den üblichen unbehandelten Novolaken als Bindemittel nach einer solchen Wärmebehandlung keine sauberen Strukturen mehr. Sie sind vielmehr stark abgerundet und wesentlich breiter als ursprünglich, wobei sich vereinzelt Stege zwischen den Linien bilden.

## Ansprüche

1. Verfahren zum Abtrennen von höhermolekularen Bestandteilen aus Phenolpolymeren, dadurch gekennzeichnet, daß man das Phenolpolymer in einem organischen Lösungsmedium löst, die Lösung bei Raumtemperatur mit Ammoniak oder einem Amin im stöchiometrischen Unterschuß versetzt, das Ausgefallene abtrennt, gegebenenfalls trocknet und dann mit wäßriger Säure behandelt und den resultierenden Niederschlag abfiltriert, wäscht und trocknet.

2. Verfahren nach Anspruch 1, dadurch gekennzeichnet, daß man als organisches Lösungsmedium ein organisches Lösungsmittel oder ein Lösungsmittelgemisch verwendet.

3. Verfahren nach Anspruch 1, dadurch gekennzeichnet, daß man die Lösung mit etwa 1 bis 40 Molprozent an Ammoniak oder Amin, bezogen auf das Phenolpolymer, versetzt.

4. Verfahren nach Anspruch 1, dadurch gekennzeichnet, daß man das getrocknete Ausgefallene in organischem Lösungsmedium aufnimmt und dann mit wäßriger Säure behandelt.

5. Verfahren nach Anspruch 1, dadurch gekennzeichnet, daß man als Phenolpolymer ein Kondensationsprodukt aus gegebenenfalls substituiertem Phenol und Formaldehyd verwendet.

6. Verfahren nach Anspruch 1 oder 3, dadurch gekennzeichnet, daß man als Amin eine Verbindung verwendet, die eine Säurekonstante $pK_a$ in wäßriger Lösung bei 25 °C von größer etwa 6 besitzt.

7. Verfahren nach Anspruch 1 oder 6, dadurch gekennzeichnet, daß man als Amin Triethylamin verwendet.

8. Verfahren nach Anspruch 1 oder 6, dadurch gekennzeichnet, man als Amin Piperidin verwendet.

## Claims

1. Process for separating higher molecular weight constituents from phenol polymers, characterized in that the phenol polymer is dissolved in an organic solvent medium, the solution obtained is mixed, at room temperature, with ammonia or an amine, such that there is a stoichiometrio deficiency of ammonia or amine, the precipitate is separated, dried, if appropriate, and treated with aqueous acid, and the resulting sediment is filtered off, washed and dried.

2. Process as claimed in claim 1, characterized in that the organic solvent medium is an organic solvent or a solvent mixture.

3. Process as claimed in claim 1, characterized in that the solution is mixed with about 1 to 40 mole percent of ammonia or amine, relative to the phenol polymer.

4. Process as claimed in claim 1, characterized in that the dried precipitate is taken up in an organic solvent medium and then treated with aqueous acid.

5. Process as claimed in claim 1, characterized in that the phenol polymer is a condensation product of optionally substituted phenol and formaldehyde.

6. Process as claimed in claim 1 or 3, characterized in that the amine is a compound which in an aqueous solution of 25 °C has an acid constant $pK_a$ of more than about 6.

7. Process as claimed in claim 1 or 6, characterized in that the amine is triethylamine.

8. Process as claimed in claim 1 or 6, characterized in that the amine is piperidine.

## Revendications

1. Procédé pour la séparation de composants à masses moléculaires élevées, à partir de polymères phénoliques, caractérisé en ce que l'on dissout le polymére phénolique dans un milieu organique de dissolution, on ajoute à la solution, à la température ambiante, de l' ammoniac ou une amine en une quantité inférieure à la quantité stoechiométrique, on sépare le précipité, éventuellement on le sèche et on le traite ensuite par un acide en solution aqueuse, et on sépare par filtration le dépôt résultant, on le lave puis on le sèche.

2. Procédé selon la revendication 1, caractérisé en ce que l'on utilise en tant que milieu organique de dissolution un solvant organique ou un mélange de solvants organiques.

3. Procédé selon la revendication 1, caractérisé en ce que l'on ajoute à la solution environ de 1 à 40 % en mole d'ammoniac ou d'amine, par rapport au polymère phénolique.

4. Procédé selon la revendication 1, caractérisé en ce que l'on reprend dans une milieu organique de dissolution le précipité séché et on le traite ensuite par un acide en solution aqueuse.

5. Procédé selon la revendication 1, caractérisé en ce que, en tant que polymère phénolique, on utilise un

produit de condensation de phénol éventuellement substitué et de formaldéhyde.

6. Procédé selon la revendication 1 ou 3, caractérisé en ce que, en tant qu'amine, on utilise un composé qui a une constante d'acide $pK_a$, en solution aqueuse à 25° C, de plus de 6 environ.

7. Procédé selon la revendication 1 ou 6, caractérisé en ce que l'on utilise en tant qu'amine la triéthylamine.

8. Procédé selon la revendication 1 ou 6, caractérisé en ce que l'on utilise en tant qu'amine la pipéridine.

FIG. 1

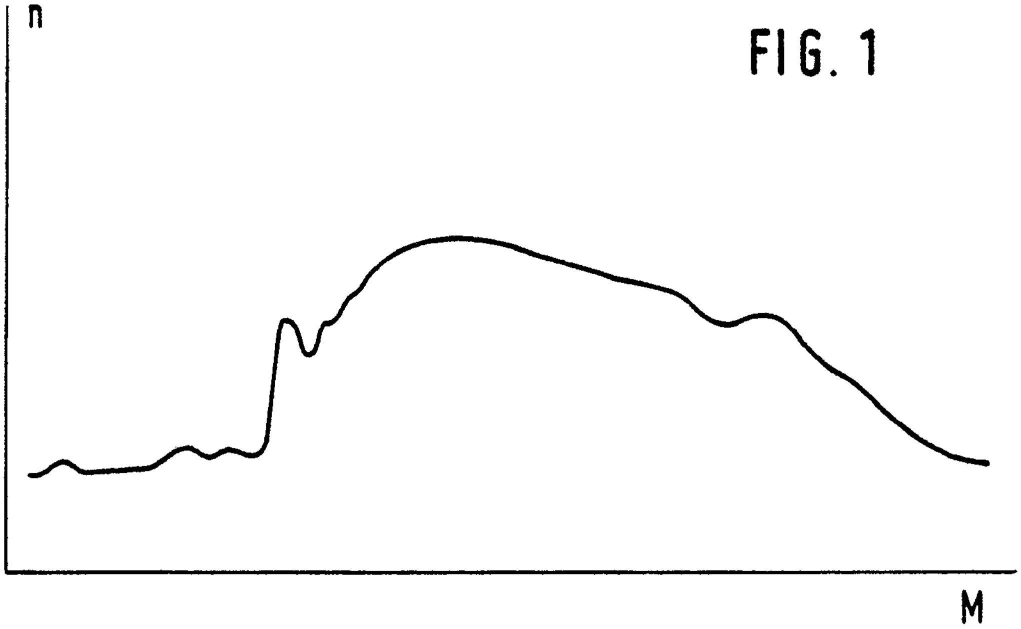


FIG. 2

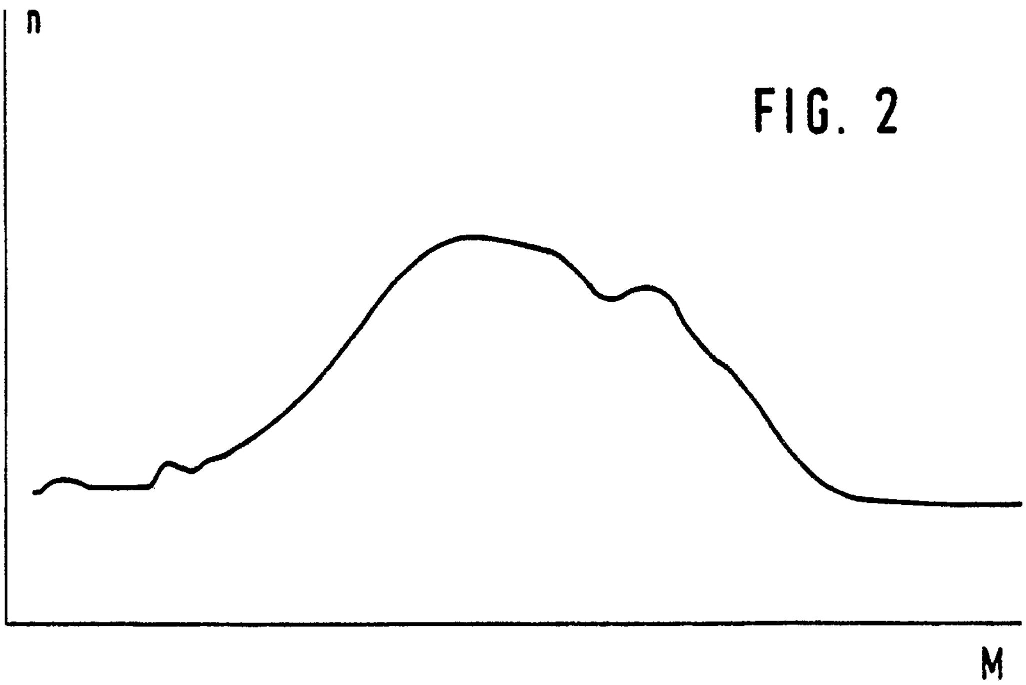


HOECHST AKTIENGESELLSCHAFT
86/K 011